(19) **Europäisches Patentamt / European Patent Office / Office européen des brevets**

(11) **EP 2 679 652 A1**

(12) # EUROPEAN PATENT APPLICATION
published in accordance with Art. 153(4) EPC

(43) Date of publication:
01.01.2014 Bulletin 2014/01

(21) Application number: 12749292.4

(22) Date of filing: 24.02.2012

(51) Int Cl.:
$C09K\ 11/00$ (2006.01)    $C09K\ 11/64$ (2006.01)
$C30B\ 29/12$ (2006.01)    $G01T\ 1/20$ (2006.01)
$G01T\ 1/202$ (2006.01)    $G01T\ 3/06$ (2006.01)

(86) International application number:
PCT/JP2012/054594

(87) International publication number:
WO 2012/115234 (30.08.2012 Gazette 2012/35)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: 24.02.2011   JP 2011038983

(71) Applicants:
• Tokuyama Corporation
  Shunan-shi
  Yamaguchi 745-8648 (JP)
• Tohoku University
  Aoba-ku
  Sendai-shi
  Miyagi 980-8577 (JP)

(72) Inventors:
• KAWAGUCHI, Noriaki
  Shunan-shi
  Yamaguchi 745-8648 (JP)
• FUKUDA, Kentaro
  Shunan-shi
  Yamaguchi 745-8648 (JP)

• SUYAMA, Toshihisa
  Shunan-shi
  Yamaguchi 745-8648 (JP)
• YOSHIKAWA, Akira
  Sendai-shi
  Miyagi 980-8577 (JP)
• YANAGIDA, Takayuki
  Sendai-shi
  Miyagi 980-8577 (JP)
• YOKOTA, Yui
  Sendai-shi
  Miyagi 980-8577 (JP)
• FUJIMOTO, Yutaka
  Sendai-shi
  Miyagi 980-8577 (JP)

(74) Representative: Schlief, Thomas P.
Patentanwälte
Canzler & Bergmeier
Friedrich-Ebert-Straße 84
85055 Ingolstadt (DE)

(54) **SCINTILLATOR FOR NEUTRON DETECTION, AND NEUTRON RADIATION DETECTOR**

(57)    To develop a novel scintillator for neutron detection that is capable of increasing the probability of inducing a nuclear reaction using epithermal neutrons having higher energy than thermal neutrons as a result of increasing thickness in the direction of incidence of neutron radiation. A scintillator for neutron detection comprising a colquiriite-type fluoride single crystal containing europium, containing 0.0025 mol% or more and less than 0.05 mol% europium, containing 0.80 atom/nm³ or more $^6$Li, and being shaped such that the thickness in the thickest part exceeds 1 mm.

EP 2 679 652 A1

**Description**

The present invention relates to a scintillator for neutron detection used for the detection of neutron radiation, and specifically, the present invention relates to the scintillator for neutron detection comprising a colquiriite-type fluoride single crystal having Eu, and a neutron radiation detector using said scintillator.

## DESCRIPTION OF THE RELATED ART

The scintillator is a substance which illuminates by absorbing the radiation when the radiation such as $\alpha$ ray, $\beta$ ray, $\gamma$ ray, X ray and neutron radiation or so contacts; and scintillator is used for the detection of the radiation by combining with a photoelectric detector such as a photomultiplier tube. Therefore, the scintillator is used in wide range of fields such as a medical field for tomography or so, an industrial field for nondestructive inspection or so, a security field for personal belongings inspection or so, an academic field such as high energy physics or so.

For scintillators, there are many types depending on the type of the radiation and the purpose of the use or so; and for example, inorganic crystals such as $Bi_4Ge_3O_{12}$, $Ce:Gd_2SiO_5$ or so, organic crystals such as anthracene or so, polymers such as polystyrene or polyvinyltoluene comprising the organic florescent or so, or liquid scintillator and gas scintillator or so may be mentioned.

Conventionally, for the detection of neutron radiation, the detector which uses $^3$He gas using $^3$He (n,p) T reaction between $^3$He and neutron radiation were mainly used. Neutron radiation has different names depending on its energy, and it is grouped into thermal neutron radiation (about 0.025 eV), epithermal neutron radiation (about 1 eV), slow neutron radiation (0.03 to 100 eV), intermediate neutron radiation (0.1 to 500 keV), fast neutron radiation (500 keV or higher) or so. Neutron radiation with high energy has low probability of $^3$He (n, p) T reaction; that is the detection sensitivity at neutron radiation detector using $^3$He gas. Therefore, the main subject of the detection of neutron radiation detector is the thermal neutron radiation with low energy.

In case of detecting neutron radiation with high energy, for example of detecting a fast neutron radiation, by using the moderator such as polyethylene or so, the method of detection of which the fast neutron radiation is moderated to the thermal neutron radiation is used. Specifically, a rem counter or Bonner sphere spectrometer of which neutron radiation detection part using $^3$He gas is covered by the polystyrene moderator having spherical shape is used. As such, neutron radiation detector combining the moderator and $^3$He gas which is highly sensitive against the thermal neutron has long been used. However, the polyethylene used as the moderator has large volume and thus the neutron radiation detector become large, hence the handling becomes difficult. Also, due to the combination with the moderator, the structure has become complicated, thus the manufacturing cost became high.

The technology which can solve the above problem is the solid scintillator for neutron detector comprising $^6$Li. In the present invention, that comprising the substance which fluoresces when neutron radiation collides is referred as scintillator for neutron detection. The scintillator for neutron detection comprising $^6$Li generates $\alpha$ ray by the nuclear reaction between the thermal neutron and $^6$Li; and fluoresces due to the excitation of scintillator by the $\alpha$ ray. The scintillator is same as $^3$He gas from the point that it has high sensitivity against the thermal neutron, however it is solid type thus there is no concern of gas leak or difficulty of sealing at high pressure as $^3$He; hence the scintillator for neutron detection having thick thickness, owing its relatively high degree of freedom of the shape when mounting on the detector, can be obtained. If the thickness along the incident direction of neutron radiation can  be increased, the chance of the nuclear reaction to occur even by the epithermal neutron having higher energy than the thermal neutron can be increased, thus the volume of the moderator can be reduced. In the detector using $^3$He gas, the gas tries to increase the thickness; hence the volume increases significantly thus the handling becomes difficult. Further, when one tends to increase the gas density by pressurizing, applicable gas pressure is limited and a risk of gas leak arises, thus it is difficult to increase the nuclear reaction probability of the epithermal neutron compared to the solid scintillator; hence the solid scintillator having thick material is demanded. However, conventionally, the material for the solid scintillator for neutron detection having thick thickness was not available.

For example, as one example of the solid scintillator for neutron detection, $^6$Li glass scintillator was used as the material without the deliquescency and having fast response; however the manufacturing process is complicated and expensive, and further it was difficult to make larger.

In order to develop new scintillator for neutron detection, the present inventors evaluated several fluoride single crystals by irradiating neutron radiation to test the application for neutron detection thereof. As a result, it was found that relatively good characteristic as the scintillator for neutron detection can be obtained by comprising lanthanoid and $^6$Li of 1.1 to 20 atoms per unit volume (atom/nm$^3$) in the fluoride crystal including Li and metal elements of bivalent or more, and further by setting the effective atomic number to 10 to 40 (refer to Patent Article 1).

Also, the present inventors have produced, using the micro-pulling down method, the scintillator for neutron detection having the thickness of 1 mm and the polished face of 2 x 10 mm which is made of $LiCaAlF_6$ having Eu among said fluoride single crystals, and found that the $LiCaAlF_6$ containing about 0.05 mol% of Eu in the crystal (corresponding to 1 mol% of Eu content in source material mixture) performs the higher luminescence amount than that containing 0.025 mol% of Eu (corresponding to 0.5 mol% of Eu content in source material mixture) (refer to Non Patent Article 1).

As the single crystal grown by a Czochralski method, the scintillator for neutron detection comprising about 0.05 mol% Eu in the crystal and having the shape of 1 mm thickness and the polished face of 2 x 10 mm is obtained; and a good neutron response characteristic as same as those produced by the micro-pulling down method is achieved (refer to Non Patent Article 2).

However, as the single crystal becomes thicker, particularly when it exceeds the thickness of 1 mm, along with the increase of the surface area of the single crystal, the efficiency of focusing the luminescence to the light receiving face of the photomultiplier tube deteriorates, hence the effective luminescence drastically declines, thereby it becomes difficult to use as the scintillator for neutron detection. Therefore, there was no report which evaluated the neutron response characteristic of the single crystal having the thickness of thicker than 1 mm, and the application as the large scintillator for neutron detection was never been considered.

[Patent Article 1] WO2009/119378

[Non-Patent Article 1] N.Kawaguchi, etc., Nuclear Science Symposium Conference Record IEEE NSS/MIC (2008) 1174-1176)

[Non-Patent Article 2] N.Kawaguchi, etc. Nuclear Science Symposium Conference Record IEEE NSS/MIC (2009) 1493-1495

## DISCLOSURE OF INVENTION

## PROBLEM TO BE SOLVED BY THE INVENTION

Regarding the scintillator for neutron detection comprising colquiriite-type fluoride single crystal having Eu, in order to develop those having a shape larger than conventional ones which exceeds the thickness of 1 mm while suppressing the decline of the amount of the luminescence along with the thickening, the present inventors produced the fluoride single crystal with various composition and detected the luminescence at the time of neutron irradiation by the photomultiplier tube and analyzed.

As a result, in case of producing the single crystal having the shape of exceeding the thickness of 1 mm, when the content of Eu is 0.05 mol% which is the same concentration as carried out in the conventional arts, the amount of the luminescence significantly decreased along with the increase of the thickness, and also the intensity of the luminescence differed depending on the position in the scintillator single crystal for neutron detection where the nuclear reaction took place; thus the signal intensity of the receiving light varied significantly. Hence, it took long time to obtain clear detection peak, which caused new problem that the performance of the detector declined.

The present invention have solved these problems, and the object of the present invention is to develop new scintillator for neutron detection capable of increasing the probability of the nuclear reaction by the epithermal neutron having higher energy than thermal neutron by increasing the thickness along the incident direction of neutron radiation.

## MEANS FOR SOLVING THE PROBLEM

According to the keen examination by the present inventors, in case the content of Eu is controlled to less than 0.05 mol% which is extremely low concentration and comprised in, the decline of the above mentioned amount of the luminescence due to the increase of the thickness is suppressed, and it was also found that the decline in performance as the scintillator for neutron detection due to the varying signal intensity did not take place.

That is, the present invention is the scintillator for neutron detection comprising the colquiriite-type fluoride single crystal having Eu, wherein further including 0.0025 mol% or more and less than 0.05 mol% of Eu, 0.80 atom/nm$^3$ or more of $^6$Li, and has a shape exceeding the thickness of 1 mm; and the neutron radiation detector comprising said scintillator for neutron detection and photomultiplier tube.

## EFFECT OF THE PRESENT INVENTION

The crystal of the present invention is usable as the neutron radiation detector which can be used for identifying the presence of neutron radiation in the environment by combining with the photomultiplier tube. Particularly, it is suitable for the neutron radiation detector with high detection efficiency with increased probability of a nuclear reaction between epithermal neutron which is preferably provided with extremely thick scintillator.

## BRIEF DESCRIPTION OF THE DRAWINGS

Fig. 1    a schematic diagram of the producing device by Czochralski method for the crystals used in the scintillator of the present invention.

Fig. 2    is a schematic diagram of the neutron radiation detector of the present invention.

Fig. 3    is a pulse-height spectrum of the scintillator for neutron detection of the present invention under thermal neutron irradiation.

Fig. 4    is a pulse-height spectrum of the scintillator for neutron detection of the present invention under epithermal neutron irradiation.

Fig. 5    is a pulse-height spectrum of the scintillator for neutron detection  of the present invention under thermal neutron irradiation.

Fig. 6    is a pulse-height spectrum of the scintillator for neutron detection of the present invention under thermal neutron irradiation.

Fig. 7    is a diagram showing the thickness dependency of the amount of the luminescence of the scintillator for neutron detection of the present invention.

## EMBODIMENTS OF THE INVENTION

The scintillator for neutron detection according to the present invention comprises colquiriite-type fluoride single crystal having Eu, wherein said colquiriite-type fluoride single crystal includes 0.0025 mol% or more and less than 0.05 mol% of Eu, and 0.80 atom/nm$^3$ or more of $^6$Li.

The basic structure of the colquiriite-type fluoride single crystal of the present invention is a single crystal of a compound expressed by the chemical formula of $M^X M^Y M^Z F_6$, wherein $M^X$ always include Li, and $M^X$ may include at least one or two elements selected from the group containing Na, K, Rb, and Cs; $M^Y$ is at least one element selected from the group containing Ca, Mg, Ba, Sr, Cd and Be; and $M^Z$ is at least one element selected from the group containing Al, Ga and In. $M^X$ always include Li which is necessary for the detection of neutron, and it preferably includes Na in case of regulating the electric charge.

Said single crystal is a hexagonal crystal which belongs to space group P31 c, and it can be easily identified by means of powder X ray diffraction.

Among the single crystal of the compound expressed by the above chemical formula, the colquiriite-type single crystal expressed by the chemical formula of $LiCaAlF_6$, $LiSrAlF_6$, $LiCa_{1-x}Sr_xAlF_6$ (0 <x< 1) are preferable, because these are easy to produce as a large crystal, and these have large amount of the luminescence when used as the scintillator. Particularly, $LiCaAlF_6$ is most preferable since it has small effective atomic number, that is it has small sensitivity against $\gamma$ ray.

Note that, in the present invention, the effective atomic number is an index defined by the following formula:

$$\text{Effective atomic number} = (\Sigma W_i Z_i^4)^{1/4}$$

(In the formula, Wi is the mass fraction of the ith element among the element constituting the scintillator, and Zi is the atomic number of the ith element among the element constituting the scintillator.)

In the present invention, the content of $^6$Li of colquiriite-type fluoride single crystal is 0.80 atom/nm$^3$ or more. By setting the content of $^6$Li to 0.80 atom/nm$^3$ or more, the sufficient sensitivity against neutron radiation which is necessary to be used as the scintillator for neutron detection can be obtained. In order to further enhance the sensitivity against neutron radiation, said content of $^6$Li is preferably about 4 atom/nm$^3$ or more.

The upper limit of the content of $^6$Li is about 9 atom/nm$^3$. The content of $^6$Li which can be comprised in the colquiriite-type fluoride single crystal is theoretically about 9 atom/nm$^3$ at most, and the content of $^6$Li having more than

this cannot be obtained.

In the present invention, the content of $^6$Li refers to the number of the $^6$Li element included per 1 $nm^3$ of the scintillator. The entered neutron generates $\alpha$ ray by causing the nuclear reaction between $^6$Li thereof. Therefore, said content of $^6$Li influences the sensitivity against neutron radiation and the more the content of $^6$Li is the more the sensitivity against neutron improves.

Said content of $^6$Li can be regulated accordingly by selecting the chemical composition of suitable scintillator for neutron detection, or by regulating the abundance ratio of $^6$Li of LiF or so used as Li source material. Here, the abundance ratio of $^6$Li is the abundance ratio of $^6$Li against the entire Li, and the abundance ratio of natural $^6$Li is about 7.6 %. As the method for regulating the abundance ratio of $^6$Li, the method of regulating by condensing to the expected $^6$Li abundance ratio using the general purpose source material comprising $^6$Li in a natural abundance ratio as the starting material; or the method of regulating by preparing the condensed source material of which $^6$Li is condensed more than the expected $^6$Li abundance ratio, then by mixing the condensed source material and said general purpose material or so may be mentioned.

Note that, the above mentioned content of $^6$Li can be determined by the following formula [1]:

$$\text{The content of } ^6\text{Li} = A \times C \times \rho \times 10^{-23}/M \text{ [1]}$$

(In the formula, $\rho$ is the density [$g/cm^3$] of the colquiriite-type fluoride single crystal used for the scintillator of the present invention; M [g/mol] is the molecular weight of the colquiriite-type fluoride single crystal used for the scintillator of the present invention; C is the abundance ratio [%] of $^6$Li against the entire Li in the Li source material; and A is Avogadro's number [$6.02 \times 10^{23}$].)

The colquiriite-type fluoride single crystal used in the present invention is a colorless crystal or a transparent crystal colored slightly, and has good chemical stability, further, in general use, the deterioration of the performance in a short period time is not recognized. Further, it has good mechanical strength and processability; hence it can be easily processed into a desired shape for use.

The shape of the scintillator for neutron detection of the present invention  must be made larger than 1 mm thickness. The thickness in the present invention refers to the length of the vertical direction with respect to the light receiving face when the scintillator for neutron detection is attached to the light receiving face of the photomultiplier tube. The typical shape is a rectangular parallel piped shape or a cubic shape having the shortest side length of more than 1 mm, or a disc shape or a cylindrical shape having the length of vertical direction with respect to the circle of more than 1 mm. If the thickness is thicker such as 1.5 mm or more, 2 mm or more, 4 mm or more, 10 mm or more, the probability of the nuclear reaction of neutron radiation and $^6$Li comprised in the scintillator for neutron detection can be improved; hence the detection efficiency for neutron radiation can be enhanced therefore it is more preferable. Also, if it is too thick, along with the increase of the surface area of the single crystal, the efficiency of focusing to the luminescence to the light receiving face of the photomultiplier tube deteriorates; therefore the upper limit of the thickness is preferably 200 mm or so.

In case $^6$Li (the cross section for neutron of 0.025 eV is about 940 barn) is comprised about 9 atom/$nm^3$ or so, by setting the thickness to more than 1 mm, the probability of the nuclear reaction with the thermal neutron exceeds 50 %, and it reaches about 60 %, hence it becomes the neutron detection efficiency for a practical use. In case of detecting the thermal neutron further sufficiently, the thickness may be further increased; and the probability of causing the nuclear reaction is about 70 % or more at thickness of 1.5mm or more, about 80 % or more at the thickness of 2 mm or more, and about 90 % or more at the thickness of 4mm or more. Note that, this is in case $^6$Li is comprised about 9 atom/$nm^3$ or so and the detection target is limited to thermal neutron of 0.025 eV; hence if $^6$Li density is lower or the detection target is widened to epithermal neutron of about 1 eV, it is preferable to make further thicker. With respect to epithermal neutron of about 1 eV (the cross section of $^6$Li for neutron is declined to about 1/5 or less), it is preferable to make the thickness to 10 mm or more of which the probability of the nuclear reaction with $^6$Li is about 70 % or more.

The colquiriite-type fluoride single crystal used in the present invention comprises Eu element. By comprising said element, the luminescence comprising the light in wavelength region around 370 nm which can be easily received by the photomultiplier tube during neutron irradiation can be obtained. It is extremely important to control the content of Eu element comprised in the colquiriite-type fluoride single crystal, in case of producing the scintillator for neutron detection of the present invention having a thickness exceeding 1 to 10 mm in order to obtain the high neutron detection efficiency as mentioned in above.

In order to obtain the luminescence at the neutron irradiation, the content of the Eu element needs to be 0.0025 mol% or more with respect to the single crystal compound of the basic structure. When the content of Eu element is comprised 0.01 mol% or more, it is further preferable since higher luminescence intensity during the neutron irradiation can be easily obtained. Also, the content of Eu element needs to be suppressed to less than 0.05 mol%. When the content is 0.05 mol% or more, in case the scintillator for neutron detection of the present invention has a size exceeding the thickness of 1 mm, the scintillator tends to easily cause the reduction of the amount of the luminescence during the thermal neutron irradiation along with the increase of the single crystal thickness.

Such trouble can be prevented further surely by suppressing the content of Eu element to 0.04 mol% or less, thus it is further preferable.

Also, the colquiriite-type fluoride single crystal used in the present invention may further include at least one element selected from transition metals and rare-earth elements. Note that, in the present invention, as the transition metals Ti, V, Cr, Mn, Fe, Co, Ni, Cu, Zn are suitably used, and as rare-earth elements Ce, Pr, Nd, Er, Tm, Ho, Dy, Tb, Gd, Sm, Yb, La, Lu, Y, Sc, Pm are suitably used. By comprising at least one element selected from the group consisting of these elements, the colquiriite-type fluoride single crystal with increased luminescence of the different wavelength from luminescence derived from Eu can be obtained. The content of these elements are preferably suppressed less than the content of Eu, not to quench the luminescence derived from Eu.

When introducing Eu during the production steps of the colquiriite-type fluoride single crystal, the segregation phenomena may be observed in the crystals. Even in case said segregation phenomena is observed, the effective segregation coefficient (k) is determined in advance to regulate the content of Eu in the source material based on the following formula [2], thereby the colquiriite-type fluoride single crystal having the desired content of Eu can be easily obtained.

$$C_S = kC_0(1-g)^{k-1} \ [2]$$

(In the formula, $C_S$ is the content [mol% (rare earth/Ca)] of Eu in the colquiriite-type fluoride single crystal, k is the effective segregation coefficient, $C_0$ is the content [mol% (rare earth/Ca)] of Eu in the source material, and g is the solidification fraction).

As the effective segregation coefficient, the value described in the literature (for example, Growth of Ce-doped $LiCaAlF_6$ and $LiSrAlF_6$ single crystals by the Czochralski technique under $CF_4$ atmosphere) may be adopted. Note that, the effective segregation coefficient differs depending on the means of the growth, and according to the examination by the present inventors, the effective segregation coefficient of Eu with respect to $LiCaAlF_6$ was 0.025 in case of Czochralski method shown in Non-Patent article 2, and was 0.05 in case of micro-pulling down method shown in Non-Patent article 1.

Also, the content of Eu in the actual crystal can be determined based on the general methods for the element analysis (for example, ICP mass spectrometry, ICP emission spectrophotometry or so).

The production method of the colquiriite-type fluoride single crystal used in the present invention is not particularly limited, and it can be produced by the known crystal production method, however it is preferably produced by Czochralski method. By using Czochralski method, the colquiriite-type fluoride single crystal having Eu with excellent quality such as transparency or so can be produced, and also a large crystal having a diameter of several inch can be produced.

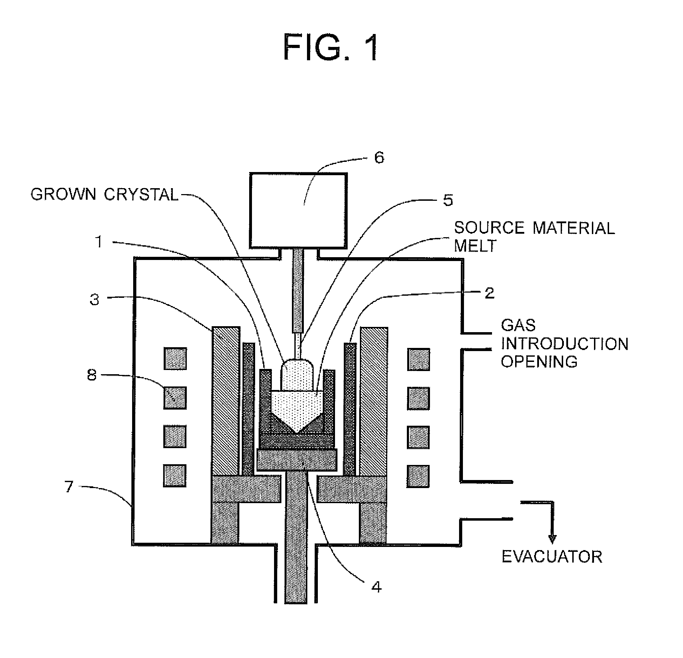

Hereinbelow, a general method of producing the colquiriite-type fluoride single crystal used in the present invention by Czochralski method will be explained based on Fig. 1.

First, the predetermined amount of source material is filled into the crucible 1. In case at least one element selected from the group consisting of $M^X$, $M^YF_2$, $M^ZF_3$ and $EuF_3$ and further transitional metals and rare-earth elements as the source materials, it is preferable to use the fluorides of said elements. The purity of these fluorides are not particularly limited, and it is preferably 99.99 % or higher respectively. Further, when producing, it is preferable to use the mixed source material of which the fluorides thereof are mixed in. By using said mixed source material, the purity of the crystal can be enhanced and the characteristics such as the luminescence intensity or so can be improved. The mixed source material may be used in a powder form or particulate form, or it may be sintered or melt-solidified in advance.

In the source material of LiF which is always comprised in $M^XF$, it is preferable to use those concentrated with $^6$Li from the point of being easy to regulate the content of $^6$Li of the colquiriite-type fluoride single crystal. In order to enhance the detection sensitivity of the thermal neutron, it is preferable to use those having the abundance ratio of $^6$Li in the Li element exceeding 7.6 %. The higher the abundance ratio of $^6$Li is, the more preferable it is since neutron detection becomes higher when the grown crystal is used as the scintillator for neutron detection.

In the above mentioned mixed source material, the source material of the crystal compound which becomes the basic structure can be scaled and mixed to have same ratio as the ratio of the chemical formula of said produced compound.

The scaled value of $EuF_3$ comprised in the colquiriite-type fluoride single crystal used in the present invention is preferably scaled so that it is more than the aiming content considering the above mentioned segregation phenomena. The segregation coefficient used for calculating the actual content of the added element from the scaled value is preferably determined from the actual concentration based on element analysis or so for each crystal production condition, since the segregation coefficient varies depending on the type of the added element or the growth condition such as the growth speed or so. The same applies when the transition metals and the rare-earth elements are comprised in.

Also, the source material powder having high volatility at high temperature may be mixed by excess portion. The volatile loss differs completely depending on the crystal growth condition (temperature, atmosphere, process setup), thus it is preferable to determine the scaled value by determining the volatile loss in advance.

Next, the crucible 1 filled with the above mentioned source material, the heater 2, the heat insulating material 3 and the movable stage 4 are set as shown in Fig. 1. A double crucible structure may be made in which another crucible with a hole at the bottom is placed above the crucible 1 by hanging and fixing to the heater 2 or so.

Also, the seed crystal 5 is attached to the tip of the automatic diameter regulating device 6.

As the seed crystals, the metals having high melting points such as platinum or so may be used instead, however by using the colquiriite-type fluoride single crystal or the single crystal having a close crystal structure therewith, crystallinity of the grown crystal tends to be good. For example, $LiCaAlF_6$ single crystal having the rectangular parallel piped shape of a size about 6 x 6 x 30 $mm^3$ or so being cut, ground, and polished along the c axis direction of the side having 30 mm can be used.

The automatic diameter regulating device measures the total weight of the seed crystal and the grown crystal, then regulates the pulling speed of the seed crystal based on the information thereof, thereby controls the diameter of the grown crystal; and the load cell for the pulling device which are commercially available for the crystal growth of Czochralski method can be used.

Next, by using the evacuator, inside of the chamber is evacuated to $1.0 \times 10^{-3}$ Pa or less, then inert gas such as high purity Argon or so is introduced into the chamber thereby the gas exchange is carried out. The pressure inside the chamber after the gas exchange is not particularly limited, and generally it is at atmospheric pressure. By this gas exchange procedure, the water attached to the source material or in the chamber can be removed, and the deterioration of the crystal derived from said water can be prevented.

In order to avoid adverse effect of the water of which cannot be removed even by above mentioned gas exchange procedure, solid scavenger such as zinc fluoride or so, or a gaseous scavenger such as methane tetra fluoride or so are preferably used. In case of using the solid scavenger, it is preferable to employ the method of mixing in the source material in advance, and in case of using the gaseous scavenger, it is preferable to employ the method of mixing with the above mentioned inert gas, then introducing into the chamber.

After carrying out the gas exchange procedure, the source material is heated by the high frequency coil 8 and the heater 2 to melt. The method of heating is not particularly limited, and for example, instead of the constitution of the above mentioned high frequency coil and the heater, the carbon heater of resistance heater type can be used accordingly.

Next, the melted source material melt is contacted with the seed crystal. The heater output is regulated so that the temperature which the portion being in contact with the seed crystal solidifies, then under the control of the automatic diameter regulating device, the crystal is pulled by automatically controlling the puling speed. During the growth, the movable stage 4 may be moved appropriately in order to regulate the liquid height. By regulating the output of the high frequency coil appropriately, grown crystal is separated from the liquid face when it reaches the desired length, then by cooling while taking sufficient time so that the grown crystal is not cracked, the colquiriite-type fluoride single crystal having Eu can be obtained.

An annealing treatment for the grown crystal may be carried out in order to remove the crystal defect caused by thermal strain or by the deficiency of the fluorine atom.

The obtained colquiriite-type fluoride single crystal having Eu is used by processing into a desired shape. Upon processing, a cutter such as known blade saw, wire saw or so, a grinder or a polisher can be used without any particular limitation.

Although the shape of the scintillator for neutron detection of the present invention is not particularly limited; it comprises a light emitting face opposing the photomultiplier tube which will be described in the following, and the thickness in the vertical direction to the light emitting face is more than 1 mm. As mentioned in above, the thickness may be 2 to 10 mm or more depending on the purpose. Said light emitting face is preferably finished by an optical polishing. By having such light emitting face, the light generated by the scintillator can enter the photomultiplier tube efficiently.

Note that, the shape of said light emitting face is not particularly limited, the shape depending on the use can be accordingly selected such as square shape having the length of one side of several mm to several hundred mm, or a circle shape having a diameter of several mm to several hundred mm.

Also, by placing the light reflecting film formed from such as aluminum or Teflon (TM) or so to the face which does not oppose the photomultiplier tube, the dissipation of light generated by the scintillator can be prevented, thus it is preferable.

The scintillator for neutron detection of the present invention can be neutron radiation detector by combining with the photomultiplier tube.

That is, by converting the light emitted from the scintillator for neutron detector by the neutron irradiation (scintillation light) to an electrical signal using the photomultiplier tube, the presence and the intensity of neutron radiation can be taken as the electrical signal.

The scintillator for neutron detection of the present invention attaches to the light receiving face of the photomultiplier tube using arbitrary optical grease or so, thereby the neutron radiation detector can be made. The light receiving face of the photomultiplier tube attached with the scintillator for neutron detection may be covered by a light blocking material made of arbitrary materials which scarcely pass the light through in order to prevent the light in the environment from entering. The faces other than the face attaching to the light receiving face of the photomultiplier tube of the scintillator for neutron detection may be covered by a reflecting material made of such as aluminum, Teflon (TM), or barium sulfide or so, or it may be covered entirely by the material having both function of said reflecting material and the light blocking material. The photomultiplier tube can have high sensitivity by applying the electrical voltage, and by observing the electrical signals being outputted, the detection of neutron radiation can be verified.

The electrical signal outputted from the photomultiplier tube is inputted into an amplifier or a multichannel pulse height analyzer, and then it may be measured by photon counting. Also, it may be inputted to an ammeter such as a picoammeter or so to evaluate the current-voltage characteristic, then by verifying the change of the amperage the intensity of neutron radiation may be determined. The scintillator for neutron detection of the present invention can be used suitably with respect to the measurement by the photon counting.

Further, by using the position sensitive photomultiplier tube in which the detector comprising an array of detecting units each having a sensitive area of several millimeters square, the scintillator of the present invention is coupled so that it covers part of or all of the photo cathode window, thereby the neutron radiation imaging device can be made. For the position sensitive photomultiplier tube, those capable of detecting the scintillation light emitted from the crystal of the present invention is used. The optical grease maybe used for attaching the light receiving face and the crystal. The electrical signal output from the position sensitive photomultiplier tube can be read by using arbitrary interface, and it may be controlled using the controlling program by a personal computer.

## **EXAMPLE**

Hereinbelow, the present invention will be described using the examples of the present invention, however the present invention is not to be limited thereto.

Examples 1 to 4 and Comparative examples 1 to 8

(The production of the scintillator for neutron detection)

Below, the production method of the scintillator for neutron detection comprising colquiriite-type fluoride single crystal in regards with the examples 1, 3 and comparative 1 will be described. However as shown in Table 1, the examples 2 and 4 and the comparative examples 2 to 8 were produced by the same method except for changing the type of the added element and the scaled value of the source material.

Using the crystal production device by the Czochralski method shown in Fig. 1, the colquiriite-type fluoride single crystal used in the present invention was produced. The basic structure of said single crystal was $LiCaAlF_6$. As for the source material, high purity fluoride powder of $LiF$, $CaF_2$, $AlF_3$, $EuF_3$ having purity of 99.99 % or more were used. Note that, as $LiF$, that having 95 % of an abundance ratio of $^6Li$ was used. For crucible 1, heater 2, and insulating material 3, those made of the high purity carbon material were used.

First, 401.4 g of $LiF$, 1250.4 g of $CaF_2$, 1344.9 g of $AlF_3$, and 3.3 g of $EuF_3$ were scaled, and mixed thoroughly to make the mixed source material then it was filled in the crucible 1. At this time, in order to control the Eu content to low concentration, $EuF_3$ must be scaled in an extremely low amount compared to other source materials, thus the weight was measured using the scaling system capable of scaling more precisely, only for $EuF_3$ powder.

The crucible 1 filled with the mixed source material was placed on the movable stage 4, then the heater 2 and the insulating material 3 were sequentially set. Next, $LiCaAlF_6$ single crystal was cut into a rectangular parallel piped shape having $6 \times 6$ 30 mm$^2$ of which the side having the length of 30 mm is along the c-axis direction, followed by grinding and polishing to make seed crystal 5, and it was placed on the tip of the automatic diameter control system.

Using the evacuator comprising an oil-sealed rotary vacuum pump and an oil diffusion pump, inside of the chamber 5 was evacuated to $5.0 \times 10^{-4}$ Pa, then a tetrafluoromethane-argon gas mixture was introduced in the chamber 7 till it reaches atmospheric pressure, thereby the gas exchange was carried out.

A high frequency current was applied to the high frequency coil 8 and the source material was heated and melted by induction heating. The seed crystal 5 was moved to contact with the liquid surface of the melted source material melt. The power of the heater was regulated to the temperature at which the part contacted with the seed crystal solidified, then under the control of the automatic diameter control system, the pulling-up speed was automatically controlled targeting the diameter of 55 mm, thereby the crystal was pulled-up.

During the growth, crystal was continuously pulled-up wherein the liquid height was maintained at constant level by the movable stage 4 and power of the high frequency coil was controlled appropriately. Then, when it reached the length of about 60 mm it was separated from the liquid surface, and cooled for about 48 hours, thereby obtained the colquiriite-type fluoride single crystal used in the present invention having the basic structure of $LiCaAlF_6$ with a diameter of 55 mm and the length of about 60 mm.

The obtained crystal was cut by the wire saw equipped with a diamond wire, and the grinding and the mirror polishing were carried out, then it was processed to have a shape of length x width x thickness of 10 x 10 x 1 mm, 10 x 10 x 2 mm, and 10 x 10 x 10 mm; thereby the comparative example 1 and the scintillator for neutron detection of the present invention of examples 1 and 3 were obtained.

The obtained scintillator for neutron detection was cut out from the portion where the Eu content was about 0.0025 mol% in accordance with said formula (2) (the portion where the solidification fraction g is 1 % corresponding to the starting stage in the single crystal growth is 1 %). The content of $^6Li$ was 8.3 atom/$nm^3$.

The crystal of the examples 2 and 4 and the comparative examples 2 to 8 were produced, cut and polished in the same manner, thereby the scintillator for neutron detection of the present invention of the examples 2 and 4 and the comparative examples 2 to 8 were obtained. The content of $^6Li$ were 8.3 atom/$nm^3$ respectively, and the content of Eu derived from said equation (2) were as shown in Table 1.

Table 1

| Eu content [mol%] | Scaled value [g] | | | | Size of Scintillator for neutron detection being cut out | | |
|---|---|---|---|---|---|---|---|
| | LiF | $CaF_2$ | $AlF_3$ | $EuF_3$ | 10 x 10 x 1[mm] | 10 x 10 x 2[mm] | 10 x 10 x 10 [mm] |
| 0.0025 | 401.4 | 1250.4 | 1344.9 | 3.3 | Comparative example 1 | Example 1 | Example 3 |
| 0.025 | 397.4 | 1237.9 | 1331.5 | 33.1 | Comparative example 2 | Example 2 | Example 4 |
| 0.05 | 393.1 | 1224.4 | 1317.0 | 65.5 | Comparative example 3 | Comparative example 5 | Comparative example 7 |
| 0.1 | 384.7 | 1198.2 | 1288.8 | 128.3 | Comparative example 4 | Comparative example 6 | Comparative example 8 |

The obtained scintillator for neutron detection measured the pulse height spectrum during the thermal neutron irradiation according to the method described in below.

Examples 5 to 8 and Comparative examples 9 to 16

(The production of the neutron radiation detector equipped with the photomultiplier tube)

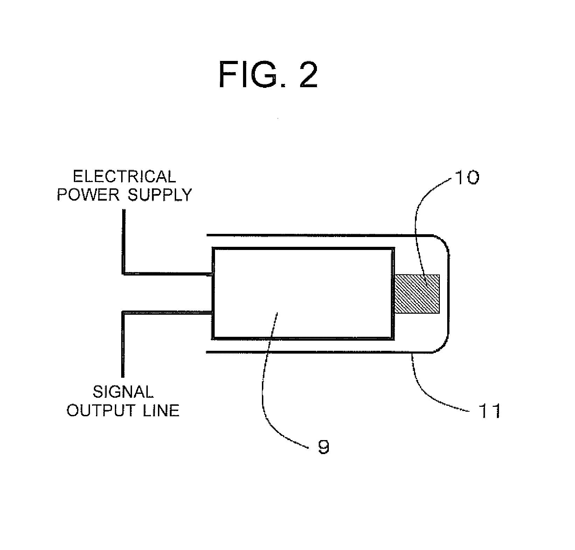

The constitution of neutron radiation detector of the present invention is shown in Fig. 2. As for the photomultiplier tube 9, R7600U made by Hamamatsu Photonics K. K. comprising the light sensitivity of about 250 nm to 750 nm was used. As for the scintillator for neutron detection 10, the scintillator for neutron detection of the example 1 was used. The face of said scintillator having the length of 10 mm, and width of 10 mm was attached to the photocathode window using the optical grease, then by blocking the light using the light blocking material 11 made of black vinyl sheet so that the light does not enter from the outside, the example 5 was made.

The neutron radiation detector for the examples 2 to 4 were produced in a same constitution and the examples 6 to 8 were made. The neutron radiation detector for the comparative examples 1 to 8 were produced in a same constitution and the comparative examples 9 to 16 were made.

$^{252}Cf$ sealed neutron source was introduced in polyethylene container and was used as the thermal neutron source. Next, the scintillation light emitted from the scintillator was measured by photon counting. First, the scintillation light was converted into the electrical signal via the photomultiplier tube 9 applied with the high voltage of 600 V. Here, the electrical signal output from the photomultiplier tube is a signal of pulse form reflecting the scintillation light, and the pulse height represent the luminescence intensity of the scintillation light, further also the pulse shape thereof show the decay curve based on the decay constant of the scintillation light. The electrical signals output from the photomultiplier tube were shaped and amplified by shaping amplifier, and then inputted into multichannel pulse-height analyzer for analysis, thereby a pulse-height spectrum was prepared.

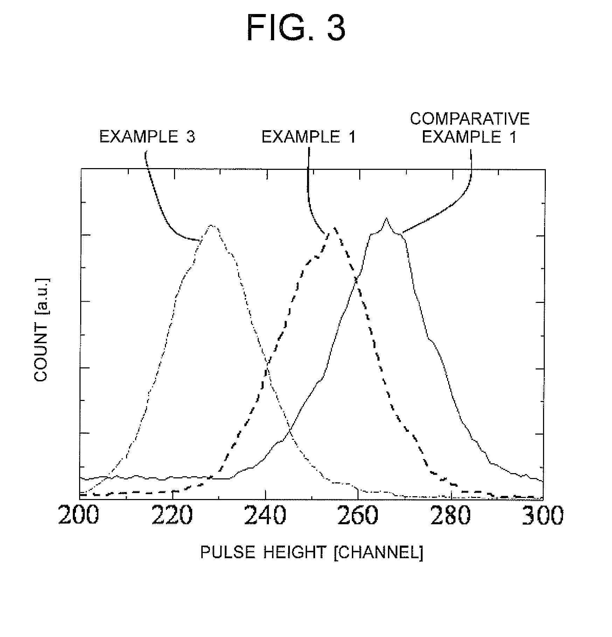

The obtained pulse-height spectrums are shown in Fig. 3 to Fig. 6. The horizontal axis of said pulse-height spectrum represents the pulse-height of the electrical signals that is of the luminescence intensity of the scintillation light. Also, the vertical axis represents the frequency of the electrical signals shown in each pulse-height.

Several pulse-height spectrums were drawn on one figure simultaneously, and the type of the scintillator for neutron detection 10 mounted was shown. Respectively, Fig. 3, 4, 5 and 6 represent the pulse-height spectra measured by scintillators of the examples 1, 3 and the comparative example 1; the examples 2, 4 and the comparative example 2; the comparative examples 3, 5, 7; the comparative example 4, 6, 8. Fig. 3 to Fig. 6 is drawn by separating based on the content of Eu.

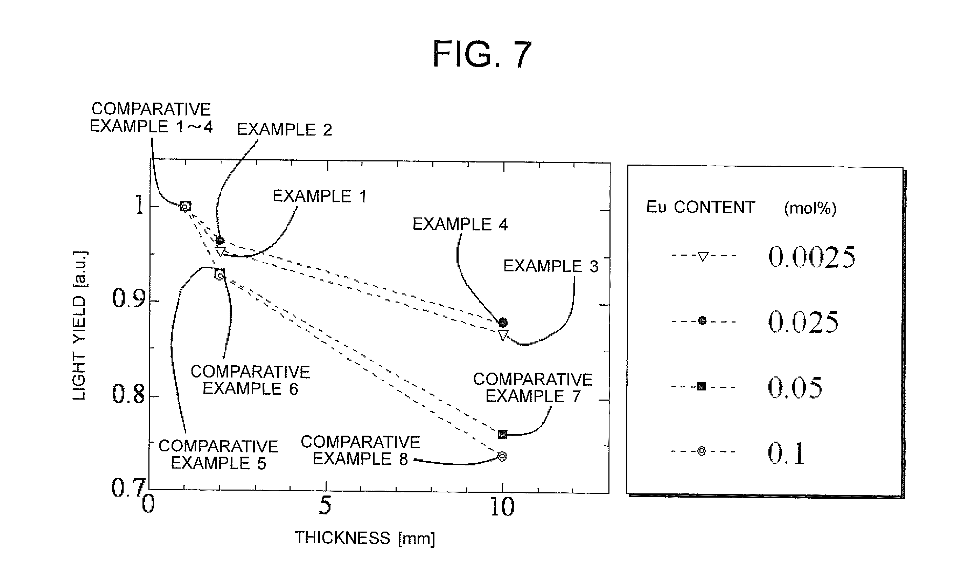

Regarding Fig. 3 to Fig. 6, reading the luminescence amount (the value of the horizontal axis) in accordance with each Eu content, the luminescence amount at the thickness of 1 mm was standardized as 1, and the result of searching the thickness dependency of the attenuation of the luminescence amount is shown in Fig. 7. According to Fig. 7, the luminescence declines significantly along with the increase of the thickness when the Eu content is 0.05 and 0.1 mol%. Also, when the Eu content was 0.025 and 0.0025 mol%, the decline of luminescence was observed, however compared to the Eu content of 0.05 and 0.1 mol%, the rate of decline is smaller by about 10 %.

As such, when the attenuation of the luminescence amount is large in case the thickness is thickened, even if it is made thicker to increase the detection sensitivity against the epithermal neutron, the thickness of the limit which can ensure the desired luminescence amount becomes small. Particularly, the thicker the scintillator is (for example, when it is thicker than 10 mm), the comparative example having the Eu content of 0.05 and 0.1 mol% has significant attenuation of the luminescence since the attenuation of luminescence amount is heavily thickness dependent. The examples having the Eu content of 0.025 and 0.0025 mol% can ensure the desired luminescence amount more suitably.

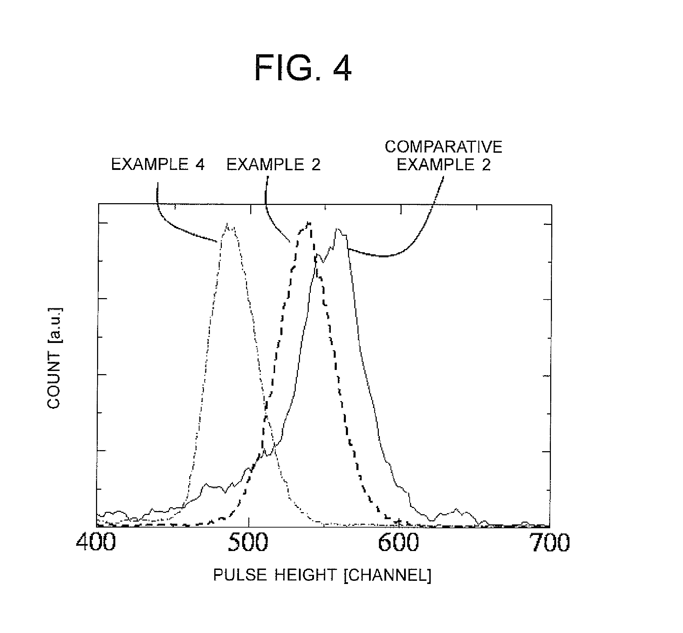

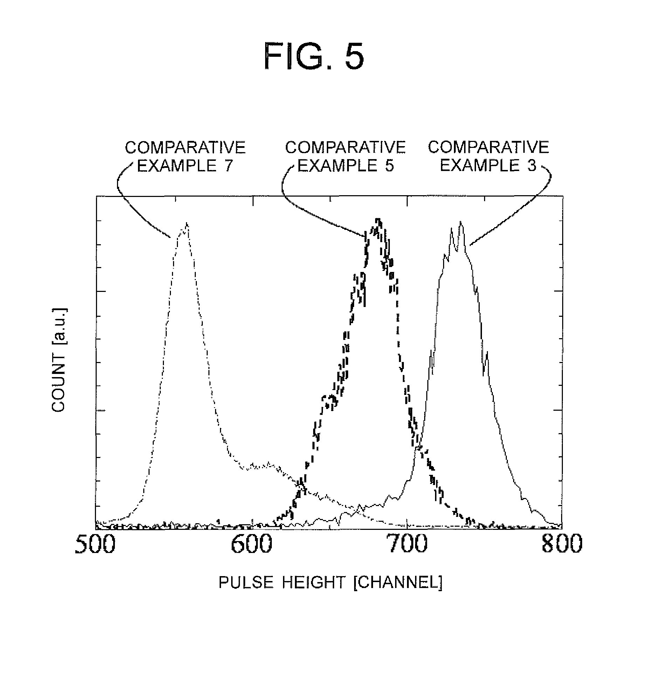

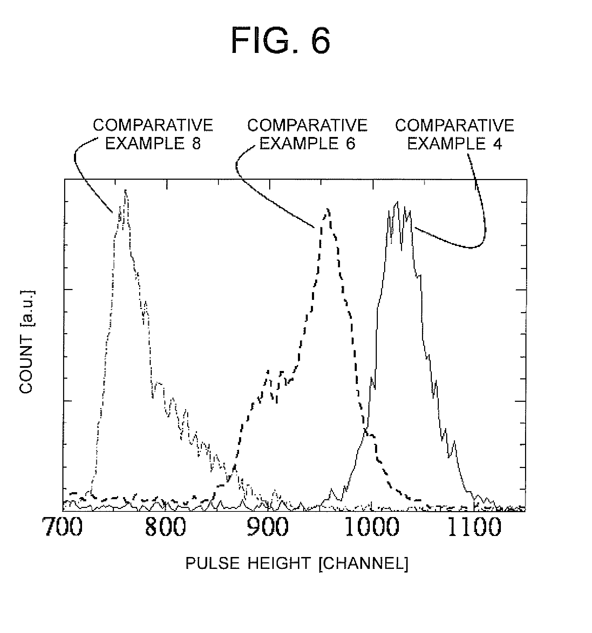

Such attenuation of the luminescence due to the thickness becomes difficult to be detected by the photomultiplier tube simply, and also the luminescence intensity varies depending on at which position the nuclear reaction took place in the scintillator single crystal for neutron detection. Then, this will cause a variation of the signal intensity which is to be received, and it becomes necessary to set the pulse-height of the detecting range high, thus the longer time will take to obtain the detection peak; thereby the detection performance declines. For example, when the comparison is made between the pulse-height spectrums of the examples 1 to 4 having Eu content of less than 0.05 mol% (Fig. 3 and Fig. 4), and the pulse-height spectrums of the comparative examples 5 to 8 comprising the Eu content of 0.05 or more (Fig. 5 and Fig. 6), the former has the pulse-height (the horizontal axis) range in which the all the peaks falls in a relatively narrow range (within 100), the latter has the pulse-height (the horizontal axis) in which the peaks spreads in a wide range (100 or more). This shows that the variation of the signal intensity of the former is small.

It is not theoretically certain why the difference of the decay amount of the luminescence amount is clearly different between the Eu content of 0.025 mol% and 0.05 mol%, as shown in Fig. 7. However, the detection peak in the pulse-height spectrum of the neutron radiation detector mounting the scintillator of the comparative examples 5 to 8 having the Eu content of 0.05 mol% showed significant left-right asymmetry. Particularly, in the pulse-height spectrum of the neutron detector mounting the scintillator of the comparative examples 6 and 7 had separated peaks, and it shows two peaks. Such separation of the peaks is not necessarily seen in every scintillator. As one characteristic phenomena of the colquiriite-type fluoride single crystal having Eu, it comprises portions with different luminescence amount in one crystal, and thus there is a possibility that may be giving unexpected influence from the known art to the scintillator performance. As such, in case of the comparative examples having Eu content of 0.05 and 0.1 mol%, when the thickness becomes thicker, the detected peaks becomes left-right asymmetric, or the separation of the detected peaks into two were observed. On the other hand, in case of the examples having the Eu content of 0.025 and 0.0025 mol%, such problem was not observed, thus the examples having lower content of Eu can be suitably used as the thick scintillator.

As discussed hereinabove, the neutron radiation detector of the examples 5 to 8 has smaller attenuation of the luminescence amount in the scintillator single crystal, and has less variation of the signal intensity when neutron radiation is detected, compared to the neutron radiation detector of the comparative examples of 9 to 16.

Also, in these pulse-height spectra, according to Figs. 3 and 4, in case the thermal neutron is irradiated to the neutron radiation detector of the examples 5 to 8, the detection peak can be obtained, and it can be seen that the scintillator for neutron detection of the present invention has sufficient luminescence amount. Further, it can be seen that by combining the photomultiplier tube and the scintillator for neutron detection of the present invention, it can be worked as the neutron radiation detector.

## NUMERICAL REFERENCES

1    Crucible
2    Heater
3    Insulating material
4    Movable stage
5    Seed crystal

6    Automatic diameter controlling system
7    Chamber
8    High frequency coil
9    Photomultiplier tube
10   Scintillator for neutron detection
11   Light blocking material

**Claims**

1. A scintillator for neutron detection comprising a colquiriite-type fluoride single crystal having Eu, wherein said scintillator for neutron detection includes 0.0025 mol% or more and less than 0.05 mol% of Eu, 0.80 atom/nm$^3$ or more of $^6$Li, and has the shape having the thickness of thicker than 1 mm.

2. The scintillator for neutron detection as set forth in claim 1, wherein a basic structure of the colquiriite fluoride single crystal is $LiCaAlF_6$.

3. A neutron radiation detector comprising a photomultiplier tube and the scintillator for neutron detection as set forth in claim 1.

# FIG. 1

GROWN CRYSTAL

SOURCE MATERIAL MELT

GAS INTRODUCTION OPENING

EVACUATOR

# FIG. 2

ELECTRICAL
POWER SUPPLY

SIGNAL
OUTPUT LINE

9

10

11

# FIG. 3

# FIG. 4

# FIG. 5

# FIG. 6

FIG. 7

EP 2 679 652 A1

## INTERNATIONAL SEARCH REPORT

| | International application No. |
|---|---|
| | PCT/JP2012/054594 |

**A. CLASSIFICATION OF SUBJECT MATTER**

*C09K11/00*(2006.01)i, *C09K11/64*(2006.01)i, *C30B29/12*(2006.01)i, *G01T1/20* (2006.01)i, *G01T1/202*(2006.01)i, *G01T3/06*(2006.01)i

According to International Patent Classification (IPC) or to both national classification and IPC

**B. FIELDS SEARCHED**

Minimum documentation searched (classification system followed by classification symbols)
C09K11/00, C09K11/64, C30B29/12, G01T1/20, G01T1/202, G01T3/06

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)
JSTPlus/JMEDPlus/JST7580(JDreamII)

**C. DOCUMENTS CONSIDERED TO BE RELEVANT**

| Category* | Citation of document, with indication, where appropriate, of the relevant passages | Relevant to claim No. |
|---|---|---|
| P,X | WO 2011/115179 A1 (Tokuyama Corp.), 22 September 2011 (22.09.2011), claims; paragraph [0027]; examples (particularly, example 5) (Family: none) | 1-3 |
| A | WO 2009/119378 A1 (Tokuyama Corp.), 01 October 2009 (01.10.2009), claims; paragraphs [0029] to [0031]; examples & US 2010/0314550 A1 & EP 2256177 A1 & CA 2717341 A1 & CN 101945974 A | 1-3 |
| A | WO 2004/086089 A1 (Hokushin Corp.), 07 October 2004 (07.10.2004), claims; page 2, line 29 to page 3, line 3; page 5, line 27; examples & US 2006/0033025 A1 | 1-3 |

☐ Further documents are listed in the continuation of Box C.   ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 07 March, 2012 (07.03.12) | 19 March, 2012 (19.03.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **N.KAWAGUCHI.** *Nuclear Science Symposium Conference Record IEEE NSS/MIC,* 2008, 1174-1176

- **N.KAWAGUCHI.** *Nuclear Science Symposium Conference Record IEEE NSS/MIC,* 2009, 1493-1495